# EUROPEAN PATENT SPECIFICATION

(11) **EP 4 500 203 B1**
(45) Date of publication and mention of the grant of the patent: **05.08.2026**
(21) Application number: 23718678.8
(22) Date of filing: 24.03.2023
(51) Int. Cl.: G01R 31/34, H02J 7/34

(54) **ELECTRONIC SENSOR FOR AN ELECTRIC MOTOR AND ELECTRIC MOTOR THEREOF**
ELEKTRONISCHER SENSOR FÜR EINEN ELEKTROMOTOR UND ELEKTROMOTOR DAFÜR
CAPTEUR ÉLECTRONIQUE POUR UN MOTEUR ÉLECTRIQUE ET MOTEUR ÉLECTRIQUE ASSOCIÉ

(30) Priority: 25.03.2022 IT 202200005927
(43) Date of publication of application: 05.02.2025
(73) Proprietor: Simotop Group S.p.A., 37122 Verona (IT)
(72) Inventor: COMAI, Guido, 40054 Budrio (Bologna) (IT); ZANNA, Alessandro, 40068 San Lazzaro di Savena (Bologna) (IT); BENTIVOGLI, Andrea, 40057 Granarolo dell'Emilia (Bologna) (IT); BARAGGIOLI, Stefano, 48124 Ravenna (IT)
(74) Representative: Penza, Giancarlo
(86) International application number: PCT/IB2023/052932
(87) International publication number: WO 2023/181002

(56) References cited:
- US-A1- 2017 201 120
- WENSI WANG ET AL: "A rotating machine acoustic emission monitoring system powered by multi-source energy harvester", ENERGY NEUTRAL SENSING SYSTEMS, ACM, 2 PENN PLAZA, SUITE 701 NEW YORK NY 10121-0701 USA, 13 November 2013 (2013-11-13), pages 1 - 6, XP058034513, ISBN: 978-1-4503-2432-8, DOI: 10.1145/2534208.2534224
- ZURITA DANIEL ET AL: "Intelligent sensor based on acoustic emission analysis applied to gear fault diagnosis", 2013 9TH IEEE INTERNATIONAL SYMPOSIUM ON DIAGNOSTICS FOR ELECTRIC MACHINES, POWER ELECTRONICS AND DRIVES (SDEMPED), IEEE, 27 August 2013 (2013-08-27), pages 169 - 176, XP032514162, DOI: 10.1109/DEMPED.2013.6645713
- FARINHOLT KEVIN ET AL: "Energy harvesting to power embedded condition monitoring hardware", PROCEEDINGS OF SPIE, IEEE, US, vol. 9433, 1 April 2015 (2015-04-01), pages 94330W - 94330W, XP060052329, ISBN: 978-1-62841-730-2, DOI: 10.1117/12.2083852
- ZIYANG WANG ET AL: "Energy-autonomous wireless vibration sensor for condition-based maintenance of machinery", 2011 IEEE SENSORS PROCEEDINGS : LIMERICK, IRELAND, 28 - 31 OCTOBER 2011, IEEE, PISCATAWAY, NJ, 28 October 2011 (2011-10-28), pages 790 - 793, XP032093597, ISBN: 978-1-4244-9290-9, DOI: 10.1109/ICSENS.2011.6127409
- MARKIEWICZ MICHAL ET AL: "Predictive Maintenance of Induction Motors Using Ultra-Low Power Wireless Sensors and Compressed Recurrent Neural Networks", IEEE ACCESS, vol. 7, 19 December 2019 (2019-12-19), pages 178891 - 178902, XP011761733, DOI: 10.1109/ACCESS.2019.2953019

## Description

### TECHNICAL FIELD OF THE INVENTION

The present invention generally relates to the field of electric motors.

More particularly, the present invention concerns an electronic sensor for an electric motor capable of recovering electrical energy from the electric motor.

### PRIOR ART

It is known to use sensors mounted on the frame of a motor, in order to measure operating parameters of the motor itself, such as for example the temperature thereof or the vibrations generated during operation.

The sensor comprises electronic components requiring a supply, which is provided by means of a battery mounted on the electronic board on which the same electronic components are mounted.

However, the battery life is limited and therefore it is necessary to replace it periodically, thus interrupting the operation of the motor for the time necessary for replacement and above all increasing the maintenance cost.

Document "A rotating machine acoustic emission monitoring system powered by multi-source energy harvester", Wensi Wang et al., ENERGY NEUTRAL SENSING SYSTEMS, ACM, 2 PENN PLAZA, SUITE 701 NEW YORK NY, 10121-0701 USA, 13 November 2013, page 1-6, discloses an energy harvesting power management subsystem harvesting thermoelectric, vibrational and photovoltaic energy, wherein the thermoelectric energy is harvested using an energy storage unit implemented with a super-capacitor.

Document "Intelligent sensor based on acoustic emission analysis applied to gear fault diagnosis", Zurita Daniel et al., 2013 9th IEEE INTERNATIONAL SYMPOSIUM ON DIAGNOSTICS FOR ELECTRIC MACHINES, POWER ELECTRONICS AND DRIVES (SDEMPED), IEEE, 27 August 2013, pages 169-176, discloses a sensor based on acoustic emission analysis applied to gear fault diagnosis, wherein the sensor records regularly the acoustic emission signal generated by gearboxes. A neural network based algorithm is applied to detect gear fault patterns. In order to reach an autonomous operation, the sensor includes an energy harvesting module based on three different energy sources: the vibration of the rotating machinery, the solar energy obtained from photovoltaic panels and thermoelectricity generators using heat dissipated by the machine.

Document "Energy harvesting to power embedded condition monitoring hardware", Farinholt Kevin et al., PROCEEDING OF SPIE, IEEE, US, vol. 9433, 1 April 2015, from page 94330W-1 to page 94330W-7, discloses a system for monitoring of dynamic events in rotating equipments such as pumps, bearings, gearboxes and electric motors. Embedded sensing hardware is powered continuously using energy collected from the nearby environment, in particular using a multi-source harvester capturing energy from thermal energy (thermoelectric generator using thermal gradients for example between the hydraulic fluid and the ambient air of a pump), electromechanical energy (vibrations) and electromagnetic energy sources (photovoltaic energy from indoor light sources).

### SUMMARY OF THE INVENTION

The present invention concerns an electronic sensor for an electric motor as defined in appended claim 1 and the preferred embodiments thereof described in dependent claims 2 to 10.

The Applicant has perceived that the electronic sensor according to the present invention makes it possible to prolong the life of the supply battery, reducing (in some cases eliminating) the number of maintenance interventions necessary for the replacement of the battery: in this way the number of interruptions of the operation of the electric motor is reduced and therefore the maintenance cost of the sensor itself is also reduced.

The present invention also relates to an electric motor as defined in the appended dependent claim 11 and in a preferred embodiment thereof described in dependent claim 12.

### BRIEF DESCRIPTION OF THE DRAWINGS

Additional features and advantages of the invention will become more apparent from the description which follows of a preferred embodiment and the variants thereof, provided by way of example with reference to the appended drawings, in which:
- Figure 1 shows a perspective view of an electric motor according to an embodiment of the invention;
- Figures 2A-2B show two perspective views of an electronic sensor for the electric motor of Figure 1;
- Figure 3A shows another view of the electronic sensor mounted on the electric motor;
- Figure 3B shows in more detail a perspective view of a support element of the electronic sensor;
- Figure 4 shows another perspective view of the support for the electronic sensor;
- Figure 5 shows a block diagram of the electronic sensor of Figure 2.

### DETAILED DESCRIPTION OF THE INVENTION

It should be observed that, in the following description, identical or analogous blocks, components or modules are indicated in the figures with the same numerical references, even if they are shown in different embodiments of the invention.

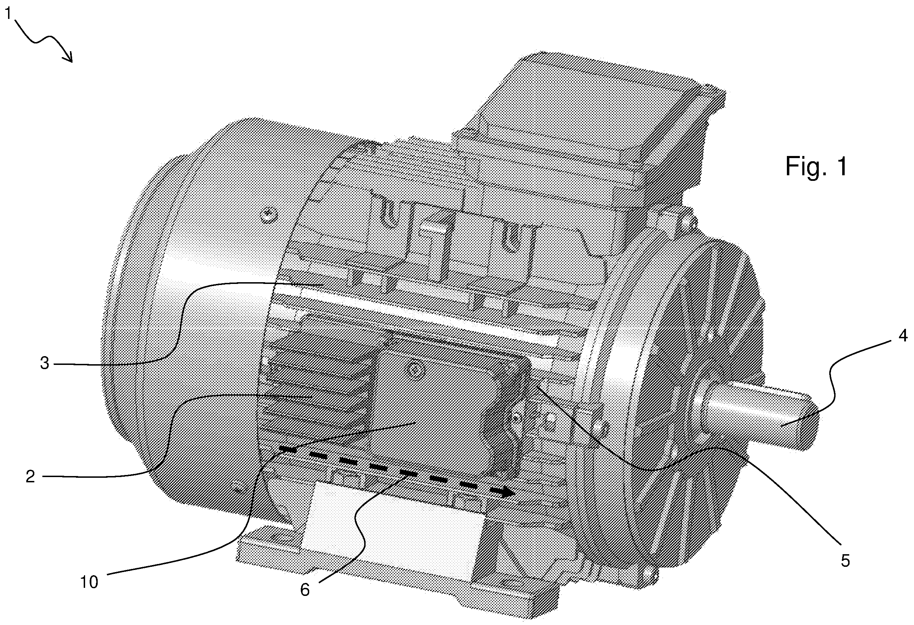

With reference to Figure 1, a perspective view of an electric motor 1 according to an embodiment of the invention is shown.

For example, the electric motor can be of the three-phase asynchronous type with 4 kW power.

The electric motor 1 comprises a metal casing enclosing a stator and a rotor, the latter mechanically coupled to a rotating shaft 4 of the motor 1, and further comprises a heat sink 3 fixed to a portion of the casing, wherein the heat sink 3 is realized for example with a plurality of cooling fins.

The electric motor 1 further comprises an electronic sensor 10 fixed to the frame of the motor 1, in particular fixed in a seat obtained in the cooling fins 3 of the motor 1 by means of an aluminium wedge, so that a portion of a thermoelectric generator 13 (which will be illustrated in more detail later) is in contact with the heat generated by the motor 1 during its operation.

The electronic sensor 10 comprises electrical and electronic components that are enclosed within a housing made of plastic material and further comprises a heat sink 2 fixed to a portion of the electronic sensor 10, in particular to a portion of the thermoelectric generator 13.

In one embodiment, the heat sink 2 is realized with a plurality of cooling fins extending along a direction that is substantially parallel to the direction of extension of the cooling fins 3 of the motor 1.

Furthermore, an air flow is generated by means of a fan mounted in the motor 1 in order to cool further the cooling fins 3, so that the direction 6 of the generated air flow is substantially perpendicular to the direction of extension of the cooling fins 3 with respect to the casing of the motor 1: the generated air flow is also substantially perpendicular to the cooling fins 2 of the thermoelectric generator 13, thus further cooling the cold surface of the thermoelectric generator 13 itself.

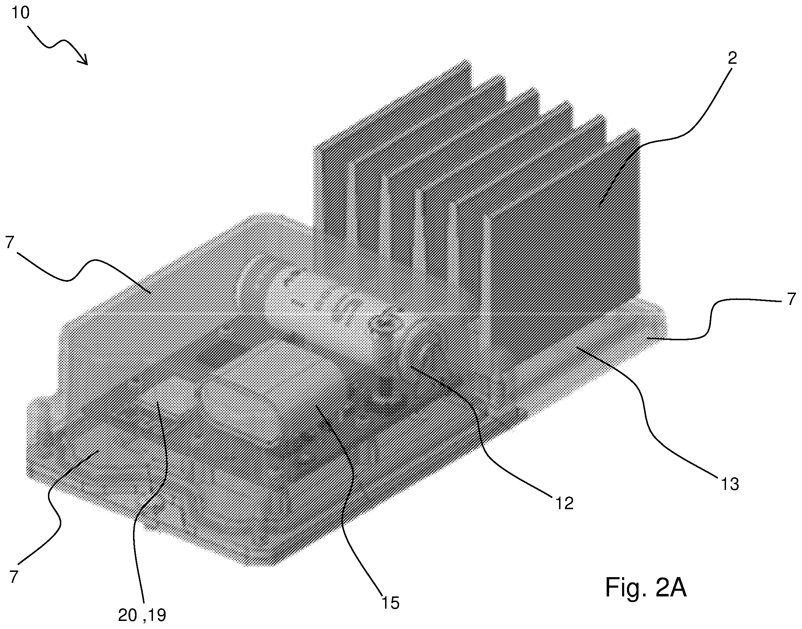

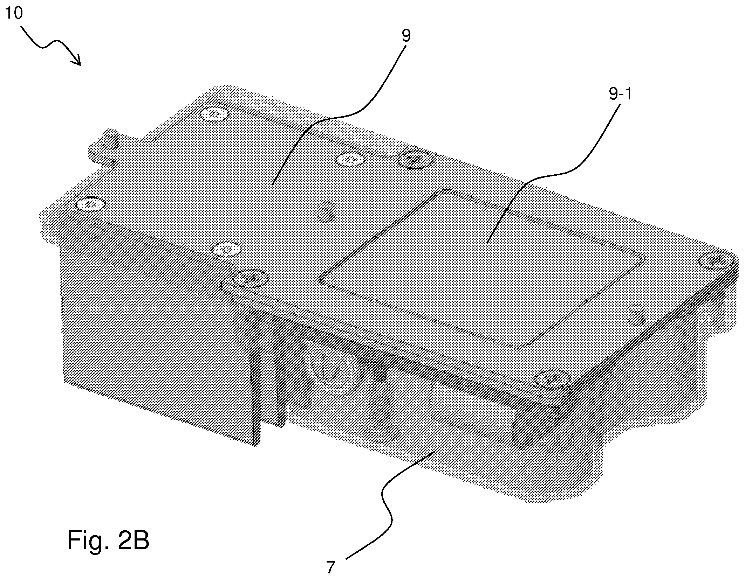

With reference to Figures 2A-2B, they show two top and bottom perspective views of the electronic sensor 10 for the electric motor 1, respectively.

It can be observed that the electronic sensor 10 comprises a casing 7 of plastic material enclosing therein a battery 12, an electrical energy accumulator 15 and the thermoelectric generator 13, wherein the casing 7 is defined below by a flat surface.

In particular, the casing 7 comprises at the bottom an opening which is closed by a flat metal sheet 9 of rectangular shape and by a plastic material element 9-1 of rectangular shape housed in an opening of the sheet 9 itself.

The sheet metal 9 has the function of thermally connecting a hot surface of the thermoelectric generator 13 to an upper surface 5-4 of a support element 5, which will be illustrated in more detail below.

The plastic material element 9-1 is positioned at the printed circuit board on which the electronic components of the sensor 10 are mounted and has the function of thermally isolating the electronic board from the motor 1.

The electronic sensor 10 and the battery 12 are mounted on the printed circuit board; instead the thermoelectric generator 13 is external to the board, but is electrically connected thereto by means of wired connections.

It is also possible to observe that the thermoelectric generator 13 has a laminar (i.e. flat) shape having two surfaces, wherein one surface (the "hot" surface) is thermally coupled with a portion of the motor 1 generating heat, while the other surface ("cold" surface) is thermally in contact with the heat sink 2: this generates a temperature difference between the hot and cold surface, therefore said temperature difference generates a flow of charges in the material interposed between the two hot and cold surfaces, thus generating a potential difference between two electrodes of the thermoelectric generator 13.

This phenomenon is called the "Seebeck effect" and is used to recharge the accumulator 15, as will be explained in more detail later.

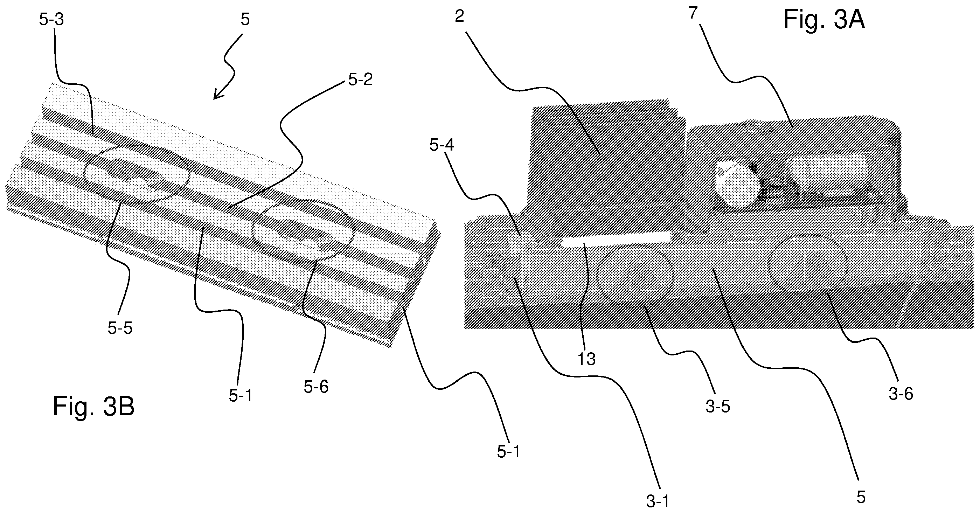

With reference to Figures 3A-3B, they shoes two views of the electronic sensor 10 when it is fixed to the electric motor 1.

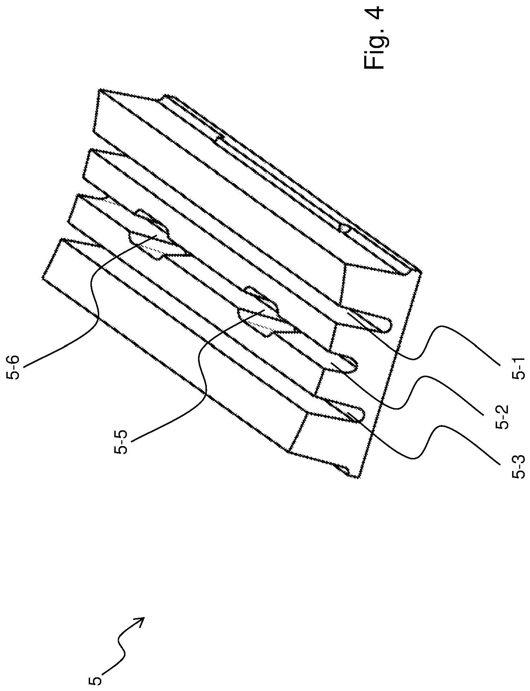

The sensor 10 comprises a support element 5 (see also figures 3B and 4) having an upper surface 5-4 on which the flat lower surface of the casing 7 of the sensor 10 is fixed.

The support element 5 further comprises a second surface opposite to the first surface, wherein the second surface comprises three grooves 5-1, 5-2, 5-3 adapted to receive three respective cooling fins of the heat sink 3, wherein the shape of the grooves 5-1, 5-2, 5-3 of the support element 5 is counter-shaped with respect to the shape of the cooling fins of the heat sink 3 so that each cooling fin of the heat sink 3 is inserted in a respective groove between 5-1, 5-2, 5-3.

The second surface of the support element 5 further comprises two openings 5-5, 5-6 adapted to receive respectively two protruding elements 3-5, 3-6 of the heat sink 3, in order to allow the correct positioning of the sensor 10 with respect to the casing of the motor 1. In particular, Figure 3A shows a cooling fin 3-1 of the heat sink 3, wherein the cooling fin 3-1 is for example inserted in the groove 5-1 of the support 5.

It can be observed that the thermoelectric generator 13 comprises a hot surface which is thermally coupled with the heat sink 3 by means of the metal sheet 9 and of the fins of the heat sink 3 inserted in the grooves 5-1, 5-2, 5-3 of the support element 5.

The use of the support element 5 with the grooves allows to increase the contact surface between the heat sink 3 and the thermoelectric generator 13, in order to obtain the hot surface of the thermoelectric generator 13.

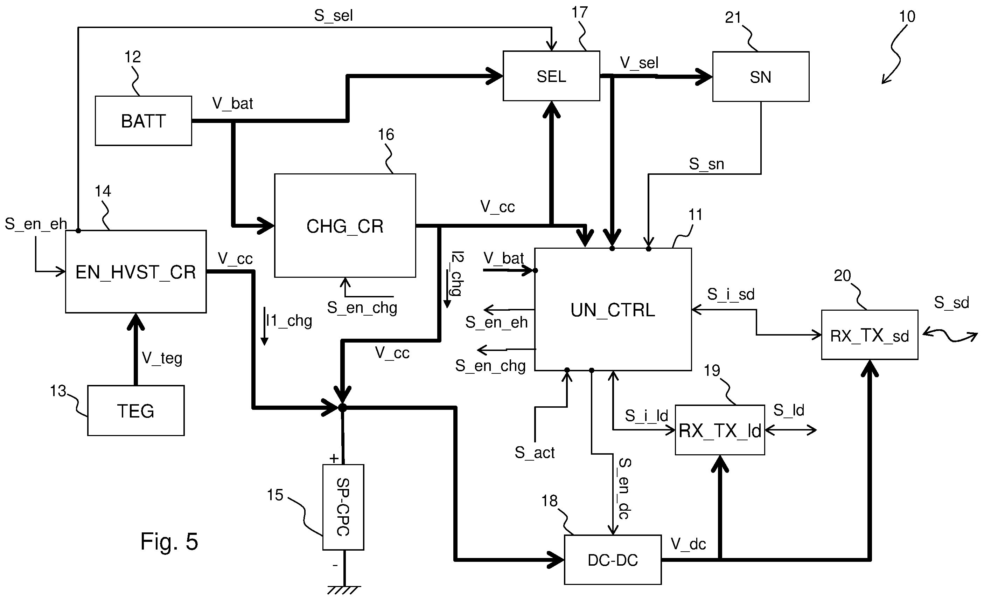

With reference to Figure 5, a block diagram of the electronic sensor 10 for the electric motor 1 is shown.

The electronic sensor 10 (also referred to as "electronic system") comprises a control unit 11, a battery 12, a thermoelectric generator 13, an energy recovery circuit 14, the electrical energy accumulator 15, a charging management circuit 16, a selector 17, a DC-DC converter 18, a long distance signal transceiver 19, a short distance signal transceiver 20 and one or more transducers 21.

The electronic sensor 10 has the function of recovering electrical energy from the motor 1 and the function of acquiring data indicative of the operation of the electric motor 1, by sending the data to a local electronic device or to a remote monitoring centre.

More particularly, the electronic sensor 10 has the function of optimizing the supply management of the long distance signal transceiver 19, of the short distance signal transceiver 20 and of the transducers 21, exploiting the electrical energy generated by means of the thermoelectric generator 13 in order to properly recharge the accumulator 15, thus minimizing the electrical energy absorbed by the battery 12, so as to greatly prolong its life.

The thermoelectric generator 13 has the function of generating a recovered voltage V_teg, converting thermal energy into electrical energy by means of the Seebeck effect as illustrated above.

In particular, the thermoelectric generator 13 comprises a positive terminal and a negative terminal, the latter connected for example to a ground reference voltage.

When there is a non-negligible temperature difference between the hot and cold surface of the thermoelectric generator 13, a voltage drop is generated between the positive terminal and the negative terminal of the thermoelectric generator 13.

For example, the temperature difference is comprised between 10 and 30 degrees and the electric power generated by the thermoelectric generator 13 is comprised between 25 mW and 100 mW.

The thermoelectric generator 13 is realized for example with the component SP1848-27145.

The accumulator 15 has the function of accumulating electrical energy, generating a charging voltage V_cc to supply the long distance signal transceiver 19 and/or the short distance signal transceiver 20.

The charging voltage V_cc may also be used to supply the control unit 11 and the transducers 21, as an alternative to the battery 12.

The accumulator 15 may be recharged (at least in part) by means of the electrical energy generated by the thermoelectric generator 13 through the electrical circuit 14, as will be explained in more detail below.

Furthermore, the accumulator 15 can be recharged (at least in part) also by means of the battery 12, as will be explained in more detail below.

The accumulator 15 is for example a rechargeable battery.

In one embodiment, the accumulator 15 is a supercapacitor having the function of accumulating electric charge, by means of the electrical energy generated by the thermoelectric generator 13 or by means of the battery 12.

The use of a supercapacitor has the advantage of providing a large amount of current in a short time, necessary to supply the long distance signal transceiver 19 and/or the short distance signal transceiver 20.

The supercapacitor 15 is realized for example with the component BMOD0002-P005 -B02 of the company Nesscap.

The energy recovery circuit 14 has the function of managing the recovery of electrical energy from the thermoelectric generator 13 and has the function of recharging at least in part the accumulator 15 by means of the electrical energy recovered from the thermoelectric generator 13, generating a first charging current I1_chg.

The energy recovery circuit 14 is electrically connected with the thermoelectric generator 13.

In particular, the energy recovery circuit 14 comprises a first input terminal adapted to receive the recovered voltage V_teg, a second input terminal adapted to receive a recovery enable signal S_en_eh and an output terminal adapted to generate the charging voltage V_cc and the first charging current I1_chg.

The energy recovery circuit 14 is such to switch between an active operating mode and an inactive operating mode, as a function of the recovery enable signal value S_en_eh, wherein in the active mode the energy recovery circuit 14 is configured to manage the recovery of electrical energy from the thermoelectric generator 13 and to at least partially recharge the accumulator 15, while in the inactive mode the energy recovery circuit 14 is switched off.

The energy recovery circuit 14 further comprises an output terminal adapted to generate a selection signal S_sel, wherein the value of the selection signal S_sel is a function of the values of the battery voltage V_bat and of the charging voltage V_cc.

In particular, the selector 17 is configured to receive the selection signal S_sel having a first value (for example, a high logic value) that selects the charging voltage V_cc: in this case the selector 17 generates in output the selected voltage V_sel equal to the charging voltage V_cc. Conversely, the selector 17 is configured to receive the selection signal S_sel having a second value (e.g., a low logic value) that selects the battery voltage V_bat: in this case the selector 17 generates in output the selected voltage V_sel equal to the battery voltage V_bat.

In one embodiment which is not part of the claimed invention, the energy recovery circuit 14 is not essential, i.e. the thermoelectric generator 13 can be directly connected to the accumulator 15, provided that the thermoelectric generator 13 and the accumulator 15 are suitably sized.

The energy recovery circuit 14 is realized for example with the electronic component bq25505 of the company Texas Instruments.

The charging management circuit 16 has the function of managing the recharge of the accumulator 15 by means of electrical energy extracted from the battery 12, in case of particular operating conditions of the electric motor 1, generating a second charging current I2_chg.

The charging management circuit 16 is electrically connected with the battery 12, the accumulator 15, the selector 17 and the control unit 11.

In particular, the charging management circuit 16 comprises a first input terminal adapted to receive the battery voltage V_bat, a second input terminal adapted to receive a charging enable signal S_en_chg and an output terminal adapted to generate the second charging current I2_chg to recharge at least in part the accumulator 15.

The charging management circuit 16 is such to switch between an inactive operating mode and an active mode as a function of the value of the charging enable signal S_en_chg, wherein:
- in the active operating mode, the charging management circuit 16 is configured to provide current to at least partially recharge the accumulator 15, by means of electrical power extracted from the battery 12;
- in the inactive operating mode, the charging management circuit 16 is deactivated, so no electric power is withdrawn from the battery 12.

The battery 12 has the function of supplying the control unit 11 and the transducers 21, in the case where the charging voltage V_cc at the ends of the accumulator 15 is not sufficient for supplying the same.

Therefore the following supply combinations are possible:
- the long distance signal transceiver 19 and/or the short distance signal transceiver 20 are supplied by means of the accumulator 15, and also the control unit 11 and the transducers 21 are supplied by means of the accumulator 15;
- the long distance signal transceiver 19 and/or the short distance signal transceiver 20 are supplied by means of the accumulator 15, while the control unit 11 and the transducers 21 are supplied by means of the battery 12.

Furthermore, the battery 12 is such to provide electrical power to at least partially recharge the accumulator 15, in the case where the thermoelectric generator 13 is such to generate a negligible voltage at the ends of its terminals.

The selector 17 has the function of generating a selected voltage V_sel selected between the battery voltage V_bat and the charging voltage V_cc, as a function of the value of a selection signal S_sel, which can be automatically generated by the energy recovery circuit 14 (as shown in Figure 5) on the basis of predefined rules at the hardware level, or it can be generated by the control unit 11 on the basis of certain rules programmable by software.

The control unit 11 comprises:
- a first input terminal adapted to receive the battery voltage V_bat;
- a second input terminal adapted to receive the accumulated voltage V_cc;
- a third input terminal adapted to receive one or more detection signals S_sn generated by the one or more transducers 21;
- a first output terminal adapted to generate a recovery enable signal S_en_eh;
- a second output terminal adapted to generate a charging enable signal S_en_chg;
- a third output terminal adapted to generate a converter enable signal S_en_dc;
- a first input/output terminal adapted to receive/transmit a first internal signal S_i_Id from/to the long distance signal transceiver 19;
- a second input/output terminal adapted to receive/transmit a second internal signal S_i_sd from/to the short distance wireless signal transceiver 20.

In one embodiment, the control unit 11 further comprises a fourth output terminal adapted to generate the selection signal S_sel, wherein the value of the selection signal S_sel is a function of the values of the battery voltage V_bat and of the charging voltage V_cc.

In particular, in the case where the value of the charging voltage V_cc is greater than a threshold value, the control unit 11 is configured to generate the selection signal S_sel having a first value (for example, a high logic value) that selects the charging voltage V_cc: in this case the selector 17 generates in output the selected voltage V_sel equal to the charging voltage V_cc. Conversely, in the case where the value of the charging voltage V_cc is lower than a threshold value, the control unit 11 is configured to generate the selection signal S_sel having a second value (for example, a low logic value) that selects the battery voltage V_bat: in this case the selector 17 generates in output the selected voltage V_sel equal to the battery voltage V_bat.

Furthermore, the control unit 11 has the function of generating the value of the charging enable signal S_en_chg to enable or disable the operation of the charging management circuit 16, as a function of the state of charge of the accumulator 15.

Furthermore, the control unit 11 is configured to exchange data with the long distance signal transceiver 19 by means of the first internal signal S_i_Id and with the short distance wireless signal transceiver 20 by means of the second internal signal S i sd.

In one embodiment, the control unit 11 is further configured to measure the state of charge of the battery 12, in particular by means of monitoring the value of the charging voltage V_cc during the time interval in which the charging management circuit 16 is active to at least partially recharge the accumulator 15, absorbing electrical energy from the battery 12: in this way it is possible to monitor the state of charge of the battery 12, without using additional circuits. The control unit 11 then performs appropriate actions as a function of the state of charge of the battery 12, such as for example sending (by means of the transceiver 19 or 20) a notification on the next discharge of the battery in order to schedule a replacement intervention before the complete discharge of the battery 12.

The control unit 11 is realized for example as a microcontroller, in particular with the component STM32L4 of the company STMicroelectronics.

The DC-DC converter 18 has the function of converting the value of the continuous type charging voltage V_cc into another direct voltage value V_dc, so that the value of the direct supply voltage V_dc is compatible with the supply voltage values allowed by the long distance signal transceiver 19 and by the short distance wireless signal transceiver 20.

The DC-DC converter 18 is interposed between the accumulator 15 and the transceivers 19, 20 and comprises a first input terminal adapted to receive the charging voltage V_cc, a second input terminal adapted to receive the converter enable signal S_en_dc and an output terminal adapted to generate the direct supply voltage V_dc.

In particular, the DC-DC converter 18 is configured to switch between an active and a deactivated operating mode, as a function of the value of the converter enable signal S_en_dc, wherein in the active mode the DC-DC converter 18 is such to perform a conversion of the voltage level between input and output in boost (increase of voltage value) or buck mode (decrease of voltage level) and wherein in the deactivated mode the DC-DC converter 18 is switched off.

The long distance signal transceiver 19 is electrically connected with the control unit 11 and has the function of exchanging data with an electronic device external to the sensor 10 crossing a telecommunications network, such as for example a server or a remote monitoring unit.

In particular, the long distance signal transceiver 19 comprises an input terminal adapted to receive the direct voltage V_dc, a first input/output terminal carrying the first internal signal S_i_Id to exchange data with the control unit 11 and comprises a second input/output terminal carrying a long distance signal S_Id to exchange data with a medium-long distance telecommunications network, in particular data indicative of operating parameters of the electric motor 1, such as for example the temperature of the motor 1, the mechanical vibrations and/or acoustic waves generated by the motor 1 during its operation, the magnetic field generated externally to the motor 1 during its operation, the humidity external to the motor 1 and the operating time interval of the motor 1.

Similarly, the short distance wireless signal transceiver 20 is electrically connected with the control unit 11 and has the function of exchanging data with a mobile electronic device positioned in proximity to the sensor 10, such as for example a smartphone, a tablet or a portable personal computer.

In particular, the short distance signal transceiver 20 comprises an input terminal adapted to receive the direct voltage V_dc, a first input/output terminal carrying the second internal signal S_i_sd to exchange data with the control unit 11 and comprises a second input/output terminal carrying a short distance radio signal S_Id to exchange data with the local mobile electronic device, in particular data indicative of operating parameters of the electric motor 1, such as for example the temperature of the motor 1, the mechanical vibrations and/or acoustic waves generated by the motor 1 during its operation, the magnetic field generated externally to the motor 1 during its operation, the humidity external to the motor 1 and the operating time interval of the motor 1.

The short distance wireless signal is for example of the Wi-Fi or Bluetooth type (in particular, Bluetooth Low Energy).

It can be observed that the long distance signal transceiver 19 and the short distance wireless signal transceiver 20 are supplied only by the accumulator 15: in this way the electric power absorbed by the battery 12 is reduced to a minimum, since the transceivers 19, 20 are the components absorbing the greatest amount of current in a short time interval in order to perform a data exchange.

Otherwise, the control unit 11 and the transducers 21 are mainly supplied by the accumulator 15, but they can also be supplied by the battery 12 under particular conditions in which the state of charge of the accumulator 15 is not sufficient for supplying the control unit 11 and the transducers 21, since the transducers 21 have a small current absorption and also the control unit 11 is mainly in a stand-by state in which power consumption is minimized.

Some examples of conditions requiring the supply of the control unit 11 and of the transducers 21 by the battery 12 are as follows:
- at the start of the electric motor 1;
- insufficient generation of electrical energy by the thermoelectric generator 13, in case of special operating conditions of the electric motor 1.

In one embodiment, the sensor 10 further comprises an interruption circuit interposed between the output terminal of the battery 12 and the input terminals of the charging management circuit 16 and of the selector 17, wherein said interruption circuit has the function of interrupting the supply voltage of the control unit 11, of the transceiver 19 or 20 and of the transducer 21, in order to cancel the energy consumption of the battery 12. This may be useful for example at the end of the production process of the sensor 10 and during the storage period, i.e. before commissioning the sensor 10.

In one embodiment (not shown in the figures), the long distance signal transceiver 19 and/or the short distance signal transceiver 20 are supplied by means of the battery 12, and also the control unit 11 and the transducers 21 are supplied by means of the battery 12, in the case where the charging voltage V_cc at the ends of the accumulator 15 is not sufficient for supplying the same, in particular in a limited time interval waiting for the accumulator 15 to be sufficiently charged.

It will be described hereinafter the operation of the electric motor 1 during a first time interval, in which it is assumed that the accumulator 15 is realized with a supercapacitor 15 which is recharged at least in part by means of the electric power generated by the thermoelectric generator 13, while the state of charge of the battery 12 remains substantially unchanged.

In particular, during the first time interval heat is generated which is dissipated by means of the cooling fins 3.

The generated heat is transferred to the hot surface of the thermoelectric generator 13, while the cold surface thereof is maintained at a lower temperature than the hot surface, by means of the thermal contact with the cooling fins 2 and by means of the air flow flowing through the cooling fins 2: the temperature gradient between the cold and hot surface of the thermoelectric generator 13 generates a potential difference V_teg between the positive and negative terminal of the thermoelectric generator 13.

The control unit 11 receives the battery voltage V_bat and the charging voltage V_cc, makes a comparison between the value of the charging voltage V_cc and a threshold value, and detects that the value of the charging voltage V_cc is greater than the threshold value. Consequently, the control unit 11 generates the recovery enable signal S_en_eh having a value enabling the operation of the energy recovery circuit 14, which in turn generates the selection signal S_sel having a value indicating the selection of the charging voltage V_cc, therefore the selector 17 generates in output the selected voltage V_sel equal to the charging voltage V_cc: the control unit 11 is thus supplied by means of the charging voltage V_cc.

The energy recovery circuit 14 is active, receives on the first input terminal the potential difference V_teg and generates, as a function thereof, the first charging current I1_chg recharging at least in part the supercapacitor 15: it is assumed that the charge is sufficient so that the voltage drop V_cc at the ends of the supercapacitor 15 is not negligible (for example, V_cc= 3.2 Volts).

The control unit 11 further generates the converter enable signal S_en_dc having a value enabling the active operating mode of the DC-DC converter 18.

The DC-DC converter 18 receives on the input terminal the direct charging voltage value V_cc and generates, as a function thereof, a direct voltage value V_dc, for example greater than the value of the charging voltage V_cc.

The long distance signal transceiver 19 receives on the input terminal the value of the direct voltage V_dc and is thus supplied by means of the electrical power stored in the supercapacitor 15: in this way the long distance signal transceiver 19 can exchange data with the telecommunications network.

Similarly, the short distance wireless signal transceiver 20 receives on the input terminal the value of the direct voltage V_dc and is thus supplied by means of the electrical power stored in the supercapacitor 15: in this way also the short distance wireless signal transceiver 20 can exchange data with the telecommunications network.

The transducers 21 receive the charging voltage V_cc and are thus supplied by means of the electric power stored in the supercapacitor 15.

Therefore during the first time interval the value of the charging voltage V_cc at the ends of the supercapacitor is sufficient for supplying the transceivers 19, 20, the control unit 11 and the transducers 21.

According to a variant, during the first time interval the selection signal S_sel is generated by the control unit 11, instead of by the energy recovery circuit 14.

The operation of the electric motor 1 during a second time interval will now be described, during which the supercapacitor 15 is recharged at least in part by means of electric power generated by the battery 12, which is thus partially discharged.

In particular, the control unit 11 receives the battery voltage V_bat and the charging voltage V_cc, makes a comparison between the value of the charging voltage V_cc and a threshold value, and detects that the value of the charging voltage V_cc is lower than the threshold value. Consequently, the control unit 11 generates the charging enable signal S_en_chg enabling the operation of the charging management circuit 16 and furthermore the control unit 11 generates the recovery enable signal S_en_eh disabling the operation of the energy recovery circuit 14, which in turn generates the selection signal S_sel having a value indicating the selection of the battery voltage V_bat, therefore the selector 17 generates in output the selected voltage V_sel equal to the battery voltage V_bat.

The control unit 11 is thus supplied by means of the battery voltage V_bat and also the transducers 21 are supplied by means of the battery voltage V_bat.

The charging management circuit 16 is active and operates by absorbing electrical power from the battery 12 and generating, as a function thereof, the second charging current I2_chg charging at least in part the supercapacitor 15.

Therefore the supercapacitor 15 is charged at least in part by means of the battery 12, while the thermoelectric generator 13 does not contribute to the recharging since the value of the voltage generated at its ends is too low.

The transceivers 19 and 20 are supplied by means of the direct voltage V_dc, which is a function of the charging voltage V_cc, with the difference (with respect to the first time interval) that at least a part of the electrical power accumulated in the supercapacitor 15 is absorbed by the battery 12, which then gets slightly discharged.

According to a variant, during the second time interval the selection signal S_sel is generated by the control unit 11, instead of by the energy recovery circuit 14.

The operation of the electric motor 1 during a third time interval will now be described, during which the supercapacitor 15 is charged in part by means of the electric power generated by the thermal generator 13 and in part by means of the electric power generated by the battery 12.

In particular, the control unit 11 receives the battery voltage V_bat and the charging voltage V_cc, makes a comparison between the value of the charging voltage V_cc and a threshold value, and detects that the value of the charging voltage V_cc is lower than the threshold value. Consequently, the control unit 11 generates the charging enable signal S_en_chg enabling the operation of the charging management circuit 16.

Furthermore, the control unit 11 generates the recovery enable signal S_en_eh enabling the operation of the energy recovery circuit 14, which in turn generates the selection signal S_sel having a value indicating the selection of the battery voltage V_bat, therefore the selector 17 generates in output the selected voltage V_sel equal to the battery voltage V_bat: the control unit 11 is thus supplied by means of the battery voltage V_bat and also the transducers 21 are supplied by means of the battery voltage V_bat.

The energy recovery circuit 14 is active, receives on the first input terminal the potential difference V_teg and generates, as a function thereof, the first charging current I1_chg recharging at least in part the supercapacitor 15.

The charging management circuit 16 is also active and operates by absorbing electrical power from the battery 12 and generating, as a function thereof, a charging current I2_chg charging at least in part the supercapacitor 15.

Therefore the supercapacitor 15 is charged in part by means of the battery 12 and in part by means of the thermoelectric generator 13, wherein the charging current I_chg comprises both a contribution given by the electrical power generated by the thermoelectric generator 13, and a contribution given by the electrical power of the battery 12, which then gets slightly discharged.

According to a variant, during the third time interval the selection signal S_sel is generated by the control unit 11, instead of by the energy recovery circuit 14.

In one embodiment, the sensor 10 is such to operate according to two operating modes:
- an active mode, in which the control unit 11 is such to operate in order to execute a firmware program for the recovery of electrical energy by means of the thermoelectric generator 13 and/or of the battery 12 as illustrated above and to carry out a monitoring of operating parameters of the motor 1;
- a stand-by mode, in which the control unit 11 is such to deactivate the operation of the charging management circuit 16, of the long distance signal transceiver 19, of the short distance wireless signal transceiver 20 and at least part of the transducers 21, for example by appropriately interrupting their supply.

In the stand-by mode the electric power consumption of the control unit 11 is therefore reduced to a minimum, thus increasing the life of the battery 12 and minimizing the energy absorption from the electrical energy accumulator 15.

The sensor 10 is such to switch between the stand-by mode and the active mode, in the case where the control unit 11 is such to receive an external activation command S_act or in the case where the control unit 11 is such to receive from the transducer 21 (connected to the control unit 11) a detection signal S_sn having an appropriate value: in this case the control unit 11 switches from the stand-by state to the active state, in order to execute the firmware program that takes in input the signal generated by the transducer 21 that has awakened the control unit 11.

The activation command S_act is for example an external signal generated by a user, for example by means of pressing a key positioned on the motor 1, wherein the key is connected with the electronic board on which the components of the sensor 10 are mounted.

In one embodiment, the control unit 11 is implemented with a microcontroller allowing to have a switching time between the stand-by mode and the active mode that is sufficiently low, such as to quickly detect possible critical defects present on the motor 1.

## Claims

1. Electronic sensor (10) for an electric motor, the sensor comprising:
- an electrical energy accumulator (15) configured to generate a charging voltage (V_cc);
- a thermoelectric generator (13) configured to generate a recovered voltage (V_teg);
- an energy recovery circuit (14) interposed between the thermoelectric generator (13) and the electrical energy accumulator (15);
- a short, medium or long distance signal transceiver (19, 20);
wherein:
• the energy recovery circuit (14) is configured to receive the recovered voltage (V_teg) and to generate therefrom a charging current (I1_chg);
• the electrical energy accumulator (15) is configured to be recharged at least in part by means of the charging current (I1_chg);
• the transceiver is supplied by means of the charging voltage (V_cc);
the electronic sensor further comprising:
- a battery (12) configured to generate a battery voltage (V_bat);
- a selector (17) configured to generate a voltage (V_sel) selected between the charging voltage (V_cc) and the battery voltage (V_batt), as a function of a selection signal (S_sel);
- a control unit (11) supplied by means of said selected voltage (V_sel), wherein the control unit is configured to generate a recovery enable signal (S_en_eh) indicative of an activation or deactivation of the operation of the energy recovery circuit (14);
wherein:
• the control unit is configured to compare the charging voltage (V_cc) with respect to a voltage threshold value and to generate, as a function of said comparison, the recovery enable signal (S_en_eh) indicative of the activation of the operation of the energy recovery circuit (14);
• the energy recovery circuit (14) is configured to receive the recovery enable signal (S_en_eh) indicative of said activation and to generate the selection signal (S_sel) indicative of the selection of the charging voltage (V_cc);
• the control unit is supplied by means of the selected voltage (V_sel) equal to the charging voltage (V_cc).

2. Electronic sensor according to claim 1, further comprising a charging management circuit (16) electrically connected to the battery, to the accumulator and to the selector, wherein the charging management circuit is configured to switch between an active and an inactive operating mode as a function of a charging enable signal (S_en_chg), wherein:
• the control unit is configured to compare the charging voltage (V_cc) with respect to a voltage threshold value and to generate, as a function of said comparison, the charging enable signal (S_en_chg) indicative of an activation of the operation of the charging management circuit (16);
• the charging management circuit (16) is configured to receive the battery voltage (V_bat) and to generate therefrom a further charging current (I2_chg);
• the electrical energy accumulator (15) is configured to be recharged at least in part by means of the charging current (I1_chg) and of the further charging current (I2_chg);

3. Electronic sensor according to claim 2, wherein the energy recovery circuit (14) is configured to generate the selection signal (S_sel) indicative of the selection of the battery voltage (V_bat),
wherein the transceiver is supplied by means of the charging voltage (V_cc),
and wherein the control unit is supplied by means of the selected voltage (V_sel) equal to the battery voltage (V_bat).

4. Electronic sensor according to claims 2 or 3, wherein:
• the control unit is configured to compare the charging voltage (V_cc) with respect to the voltage threshold value and to generate, as a function of said comparison, the recovery enable signal (S_en_eh) indicative of a deactivation of the operation of the energy recovery circuit (14);
• the charging management circuit (16) is configured to receive the battery voltage (V_bat) and to generate therefrom the further charging current (I2_chg);
• the electrical energy accumulator (15) is configured to be recharged at least in part only by means of the further charging current (I2_chg);
• the transceiver is supplied by means of the charging voltage (V_cc);
• the control unit is supplied by means of the selected voltage (V_sel) equal to the battery voltage (V_bat).

5. Electronic sensor according to any one of claims 2 to 4, wherein, alternatively:
- the energy recovery circuit (14) is configured to generate the selection signal (S_sel) indicative of the selection of the charging voltage (V_cc) or of the battery voltage (V_bat);
- the control unit (11) is configured to generate the selection signal (S_sel) indicative of the selection of the charging voltage (V_cc) or of the battery voltage (V_bat).

6. Electronic sensor according to any one of the preceding claims, wherein the electrical energy accumulator (15) is a supercapacitor.

7. Electronic sensor according to any one of the preceding claims, wherein the thermoelectric generator comprises a hot surface adapted to be in thermal contact with a hot portion of the motor casing and comprises a cold surface adapted to be in contact with a heat sink (2), wherein the thermoelectric generator is configured to generate a voltage drop at its ends which is a function of the temperature difference between the hot and cold surface.

8. Electronic sensor according to any one of the preceding claims, further comprising a transducer (21) adapted to generate a detection signal (S_sn) of operating parameters associated with the electric motor, in particular the temperature thereof or vibrations,
wherein the transducer is supplied, alternatively, by means of the charging voltage (V_cc) or of the battery voltage (V_bat).

9. Electronic sensor according to claim 8, wherein the control unit (11) is configured to operate:
- in an active mode, in which the control unit (11) is configured to execute the firmware program for charging the electrical energy accumulator (15);
- in a stand-by mode, in which the control unit (11) is configured to switch from the stand-by mode to the active mode in case of receiving the detection signal (S_sn) carrying motor operating parameters or in case of receiving an external activation command (S_act).

10. Electronic sensor according to any one of claims 2 to 9, further comprising a cutoff circuit interposed between the battery and the charging management circuit and the selector, wherein the cutoff circuit is configured to disconnect the supply voltage of the control unit, of the transceiver and of the transducer (21).

11. Electric motor (1) comprising an electronic sensor according to any one of the preceding claims,
the motor comprising a casing, a first heat sink (3) fixed to a portion of the casing and a second heat sink (2) fixed to the thermoelectric generator of the sensor,
wherein the electronic sensor is fixed to a portion of the casing,
wherein the thermoelectric generator has a laminar shape comprising a first surface in thermal contact with said portion of the casing and a second surface in thermal contact with the second heat sink (2) of the sensor.

12. Electric motor according to claim 11, wherein:
- the first heat sink comprises a plurality of protruding cooling fins (3-1);
- the sensor comprises a support element (5) comprising a surface having a plurality of grooves (5-1, 5-2, 5-3) adapted to receive the plurality of cooling fins of the first heat sink.

## Patentansprüche

1. Elektronischer Sensor (10) für einen Elektromotor, wobei der Sensor umfasst:
- einen elektrischen Energiespeicher (15), der zur Erzeugung einer Ladespannung ausgelegt ist (V_cc);
- einen thermoelektrischen Generator (13), der zur Erzeugung einer zurückgewonnenen Spannung ausgelegt ist (V_teg);
- eine Energierückgewinnungsschaltung (14), die zwischen dem thermoelektrischen Generator (13) und dem elektrischen Energiespeicher (15) angeordnet ist;
- ein Signal-Transceiver für kurze, mittlere oder große Entfernungen (19, 20);
wobei:
• die Energierückgewinnungsschaltung (14) so ausgelegt ist, dass sie die zurückgewonnene Spannung (V_teg) aufnimmt und daraus einen Ladestrom (I1_chg) erzeugt;
• der elektrische Energiespeicher (15) so ausgelegt ist, dass er zumindest teilweise mittels des Ladestroms (I1_chg) wieder aufgeladen wird;
• der Transceiver über die Ladespannung (V_cc) mit Strom versorgt wird;
wobei der elektronische Sensor ferner umfasst:
- eine Batterie (12), die dazu ausgelegt ist, eine Batteriespannung (V_bat) zu erzeugen;
- eine Auswahlvorrichtung (17), die so ausgelegt ist, dass sie in Abhängigkeit von einem Auswahlsignal (S_sel) eine Spannung (V_sel) erzeugt, die zwischen der Ladespannung (V_cc) und der Batteriespannung (V_batt) liegt;
- eine Steuereinheit (11), die mit der ausgewählten Spannung (V_sel) versorgt wird, wobei die Steuereinheit so ausgelegt ist, dass sie ein Freigabesignal für die Energierückgewinnung (S_en_eh) erzeugt, das die Aktivierung oder Deaktivierung des Betriebs der Energierückgewinnungsschaltung (14) anzeigt;
wobei:
• die Steuereinheit so ausgelegt ist, dass sie die Ladespannung (V_cc) mit einem Spannungsschwellenwert vergleicht und in Abhängigkeit von diesem Vergleich das Freigabesignal (S_en_eh) erzeugt, das die Aktivierung des Betriebs der Energierückgewinnungsschaltung (14) anzeigt;
• die Energierückgewinnungsschaltung (14) so ausgelegt ist, dass sie das Rückgewinnungsfreigabesignal (S_en_eh), das diese Aktivierung anzeigt, empfängt und das Auswahlsignal (S_sel) erzeugt, das die Auswahl der Ladespannung (V_cc) anzeigt;
• die Steuereinheit mit der gewählten Spannung (V_sel) versorgt wird, die der Ladespannung (V_cc) entspricht.

2. Elektronischer Sensor nach Anspruch 1, der ferner eine Ladesteuerschaltung (16) umfasst, die elektrisch mit der Batterie, dem Akkumulator und der Auswahlvorrichtung verbunden ist, wobei die Ladesteuerschaltung so ausgelegt ist, dass sie in Abhängigkeit von einem Ladefreigabesignal (S_en_chg) zwischen einem aktiven und einem inaktiven Betriebsmodus umschaltet, wobei:
• die Steuereinheit so ausgelegt ist, dass sie die Ladespannung (V_cc) mit einem Spannungsschwellenwert vergleicht und in Abhängigkeit von diesem Vergleich das Ladefreigabesignal (S_en_chg) erzeugt, das eine Aktivierung des Betriebs der Ladesteuerschaltung (16) anzeigt;
• die Ladesteuerschaltung (16) so ausgelegt ist, dass sie die Batteriespannung (V_bat) empfängt und daraus einen weiteren Ladestrom (I2_chg) erzeugt;
• der elektrische Energiespeicher (15) so ausgelegt ist, dass er zumindest teilweise mittels des Ladestroms (I1_chg) und des weiteren Ladestroms (I2_chg) wieder aufgeladen wird;

3. Elektronischer Sensor nach Anspruch 2, wobei die Energierückgewinnungsschaltung (14) so ausgelegt ist, dass sie das Auswahlsignal (S_sel) erzeugt, das die Auswahl der Batteriespannung (V_bat) anzeigt, wobei der Transceiver über die Ladespannung (V_cc) versorgt wird und wobei die Steuereinheit über die ausgewählte Spannung (V_sel) versorgt wird, die der Batteriespannung (V_bat) entspricht.

4. Elektronischer Sensor nach Anspruch 2 oder 3, wobei:
• die Steuereinheit so ausgelegt ist, dass sie die Ladespannung (V_cc)
mit dem Spannungsschwellenwert vergleicht und in Abhängigkeit von diesem Vergleich das Freigabesignal (S_en_eh) erzeugt, das eine Deaktivierung des Betriebs der Energierückgewinnungsschaltung (14) anzeigt;
• die Ladesteuerschaltung (16) so ausgelegt ist, dass sie die Batteriespannung (V_bat) empfängt und daraus den weiteren Ladestrom (I2_chg) erzeugt;
• der elektrische Energiespeicher (15) so ausgelegt ist, dass er zumindest teilweise ausschließlich mittels des zusätzlichen Ladestroms (I2_chg) wieder aufgeladen wird;
• der Transceiver über die Ladespannung (V_cc) mit Strom versorgt wird;
• die Steuereinheit mit der gewählten Spannung (V_sel) versorgt wird, die gleich der Batteriespannung (V_bat) ist.

5. Elektronischer Sensor
gemäß einem der Ansprüche 2 bis 4, wobei alternativ:
- die Energierückgewinnungsschaltung (14) so ausgelegt ist, dass sie das Auswahlsignal (S_sel) erzeugt, das die Auswahl der Ladespannung (V_cc) oder der Batteriespannung (V_bat) anzeigt;
- die Steuereinheit (11) so ausgelegt ist, dass sie das Auswahlsignal (S_sel) erzeugt, das die Auswahl der Ladespannung (V_cc) oder der Batteriespannung (V_bat) anzeigt.

6. Elektronischer Sensor nach einem der vorstehenden Ansprüche, wobei der elektrische Energiespeicher (15) ein Superkondensator ist.

7. Elektronischer Sensor nach einem der vorstehenden Ansprüche, wobei der thermoelektrische Generator eine heiße Oberfläche aufweist, die so ausgelegt ist, dass sie in thermischem Kontakt mit einem heißen Abschnitt des Motorgehäuses steht, sowie eine kalte Oberfläche, die so ausgelegt ist, dass sie mit einem Kühlkörper (2) in Kontakt steht, wobei der thermoelektrische Generator so konfiguriert ist, dass er an seinen Enden einen Spannungsabfall erzeugt, der eine Funktion der Temperaturdifferenz zwischen der heißen
und der kalten Oberfläche ist.

8. Elektronischer Sensor nach einem der vorstehenden Ansprüche, der ferner einen Wandler (21) umfasst, der dazu ausgelegt ist, ein Erfassungssignal (S_sn) von Betriebsparametern des Elektromotors, insbesondere dessen Temperatur oder Schwingungen, zu erzeugen, wobei der Wandler wahlweise über die Ladespannung (V_cc) oder die Batteriespannung (V_bat) mit Strom versorgt wird.

9. Elektronischer Sensor nach Anspruch 8, wobei die Steuereinheit (11) so ausgelegt ist, dass sie wie folgt arbeitet:
- in einem aktiven Modus, in dem die Steuereinheit (11) so konfiguriert ist, dass sie das Firmware-Programm zum Laden des elektrischen Energiespeichers (15) ausführt;
- in einem Standby-Modus, in dem die Steuereinheit (11) so ausgelegt ist, dass sie bei Empfang des Erfassungssignals (S_sn), das Motorbetriebsparameter enthält, oder bei Empfang eines externen Aktivierungsbefehls (S_act) vom Standby-Modus in den aktiven Modus wechselt.

10. Elektronischer Sensor gemäß einem der Ansprüche 2 bis 9, der ferner eine zwischen der Batterie und der Ladesteuerschaltung sowie der Auswahlvorrichtung angeordnete Abschaltschaltung umfasst, wobei die Abschaltschaltung so ausgelegt ist, dass sie die Versorgungsspannung der Steuereinheit, des Transceivers und des Wandlers (21) unterbricht.

11. Elektromotor (1) mit einem elektronischen Sensor gemäß einem der vorangegangenen Ansprüche,
wobei der Motor ein Gehäuse, einen ersten Kühlkörper (3), der an einem Abschnitt des Gehäuses befestigt ist, und einen zweiten Kühlkörper (2) umfasst, der am thermoelektrischen Generator des Sensors befestigt ist, wobei der elektronische Sensor an einem Anschluss des Gehäuses befestigt ist und
wobei der thermoelektrische Generator eine lamellenförmige Gestalt aufweist, die eine erste Oberfläche, die in thermischem Kontakt mit dem genannten Abschnitt des Gehäuses steht, und eine zweite Oberfläche, die in thermischem Kontakt mit dem zweiten Kühlkörper (2) des Sensors steht, umfasst.

12. Elektromotor nach Anspruch 11, wobei:
- der erste Kühlkörper eine Vielzahl von hervorstehenden Kühlrippen (3-1) umfasst;
- der Sensor ein Trägerelement (5) mit einer Oberfläche umfasst, die mehrere Nuten (5-1, 5-2, 5-3) aufweist, die zur Aufnahme, der mehreren Kühlrippen des ersten Kühlkörpers ausgelegt sind.

## Revendications

1. Capteur électronique (10) destiné à un moteur électrique, le capteur comprenant:
- un accumulateur d'énergie électrique (15) configuré pour générer une tension d'alimentation (V_cc) ;
- un générateur thermoélectrique (13) configuré pour générer une tension récupérée (V_teg);
- un circuit de récupération d'énergie (14) interposé entre le générateur thermoélectrique (13) et l'accumulateur d'énergie électrique (15);
- un émetteur-récepteur de signaux à courte, moyenne ou longue portée (19, 20);
dans lequel:
• le circuit de récupération d'énergie (14) est configuré pour recevoir la tension récupérée (V_teg) et générer à partir de celle-ci un courant de charge (I1_chg);
• l'accumulateur d'énergie électrique (15) est configuré pour être rechargé au moins en partie au moyen du courant de charge (I1_chg);
• l'émetteur-récepteur est alimenté au moyen de la tension d'alimentation (V_cc);
le capteur électronique comprenant en outre:
- une batterie (12) configurée pour générer une tension de batterie (V_bat);
- un sélecteur (17) configuré pour générer une tension (V_sel) sélectionnée entre la tension d'alimentation (V_cc) et la tension de batterie (V_bat), en fonction d'un signal de sélection (S_sel);
- une unité de commande (11) alimentée au moyen de ladite tension sélectionnée (V_sel), l'unité de commande étant configurée pour générer un signal d'autorisation de récupération (S_en_eh) indiquant une activation ou une désactivation du fonctionnement du circuit de récupération d'énergie (14);
dans lequel:
• l'unité de commande est configurée pour comparer la tension de charge (V_cc) à une valeur de seuil de tension et pour générer, en fonction de ladite comparaison, le signal d'autorisation de récupération (S_en_eh) indiquant l'activation du fonctionnement du circuit de récupération d'énergie (14);
• le circuit de récupération d'énergie (14) est configuré pour recevoir le signal d'autorisation de récupération (S_en_eh) indiquant ladite activation et pour générer le signal de sélection (S_sel) indiquant la sélection de la tension de charge (V_cc);
• l'unité de commande est alimentée au moyen de la tension sélectionnée (V_sel) égale à la tension de charge (V_cc) .

2. Capteur électronique selon la revendication 1, comprenant en outre un circuit de gestion de charge (16) électriquement connecté à la batterie, à l'accumulateur et au sélecteur, le circuit de gestion de charge étant configuré pour commuter entre un mode de fonctionnement actif et un mode de fonctionnement inactif en fonction d'un signal d'autorisation de charge (S_en_chg), dans lequel:
• l'unité de commande est configurée pour comparer la tension de charge (V_cc) à une valeur de seuil de tension et pour générer, en fonction de ladite comparaison, un signal d'autorisation de charge (S_en_chg) indiquant une activation du fonctionnement du circuit de gestion de charge (16);
• le circuit de gestion de charge (16) est configuré pour recevoir la tension de batterie (V_bat) et pour générer à partir de celle-ci un courant de charge supplémentaire (I2_chg) ;
• l'accumulateur d'énergie électrique (15) est configuré pour être rechargé au moins en partie au moyen du courant de charge (I1_chg) et du courant de charge supplémentaire (I2_chg);

3. Capteur électronique selon la revendication 2, dans lequel le circuit de récupération d'énergie (14) est configuré pour générer le signal de sélection (S_sel) indiquant la sélection de la tension de batterie (V_bat), dans lequel l'émetteur-récepteur est alimenté au moyen de la tension de charge (V_cc), et dans lequel l'unité de commande est alimentée au moyen de la tension sélectionnée (V_sel) égale à la tension de batterie (V_bat).

4. Capteur électronique selon les revendications 2 ou 3, dans lequel:
• l'unité de commande est configurée pour comparer la tension de charge (V_cc) à la valeur de seuil de tension et pour générer, en fonction de ladite comparaison, un signal d'autorisation de récupération (S_en_eh) indiquant une désactivation du fonctionnement du circuit de récupération d'énergie (14);
- le circuit de gestion de charge (16) est configuré pour recevoir la tension de batterie (V_bat) et pour générer à partir de celle-ci le courant de charge supplémentaire (I2_chg);
• l'accumulateur d'énergie électrique (15) est configuré pour être rechargé au moins en partie uniquement au moyen du courant de charge supplémentaire (I2_chg);
• l'émetteur-récepteur est alimenté au moyen de la tension de charge (V_cc);
• l'unité de commande est alimentée au moyen de la tension sélectionnée (V_sel) égale à la tension de batterie (V_bat).

5. Capteur électronique
Selon l'une quelconque des revendications 2 à 4, dans lequel, alternativement:
- le circuit de récupération d'énergie (14) est configuré pour générer le signal de sélection (S_sel) indiquant la sélection de la tension de charge (V_cc) ou de la tension de batterie (V_bat);
- l'unité de commande (11) est configurée pour générer le signal de sélection (S_sel) indiquant la sélection de la tension de charge (V_cc) ou de la tension de batterie (V_bat) .

6. Capteur électronique selon l'une quelconque des revendications précédentes, dans lequel l'accumulateur d'énergie électrique (15) est un supercondensateur.

7. Capteur électronique selon l'une quelconque des revendications précédentes, dans lequel le générateur thermoélectrique comprend une surface chaude destinée à être en contact thermique avec une partie chaude du carter du moteur et comprend une surface froide destinée à être en contact avec un dissipateur thermique (2), le générateur thermoélectrique étant configuré pour générer une différence de potentiel à ses bornes, fonction de la différence de température entre la surface chaude et la surface froide.

8. Capteur électronique selon l'une quelconque des revendications précédentes, comprenant en outre un transducteur (21) apte à générer un signal de détection (S_sn) de paramètres de fonctionnement associés au moteur électrique, en particulier sa température ou ses vibrations, ledit transducteur étant alimenté, de manière alternative, au moyen de la tension de charge (V_cc) ou de la tension de batterie (V_bat).

9. Capteur électronique selon la revendication 8, dans lequel l'unité de commande (11) est configurée
pour fonctionner:
- en mode actif, dans lequel l'unité de commande (11) est configurée pour exécuter le programme embarqué de charge de l'accumulateur d'énergie électrique (15);
- en mode veille, dans lequel l'unité de commande (11) est configurée pour passer du mode veille au mode actif en cas de réception du signal de détection (S_sn) portant des paramètres de fonctionnement du moteur ou en cas de réception d'une commande d'activation externe (S_act) .

10. Capteur électronique selon l'une quelconque des revendications 2 à 9, comprenant en outre un circuit de coupure interposé entre la batterie, le circuit de gestion de charge et le sélecteur, le circuit de coupure étant configuré pour interrompre la tension d'alimentation de l'unité de commande, de l'émetteur-récepteur et du transducteur (21).

11. Moteur électrique (1) comprenant un capteur électronique selon l'une quelconque des
revendications précédentes,
le moteur comprenant un carter, un premier dissipateur thermique (3) fixé à une partie du carter et un second dissipateur thermique (2) fixé au générateur thermoélectrique du capteur, le capteur électronique étant fixé à une partie du carter,
le générateur thermoélectrique présentant une forme lamellaire comprenant une première surface en contact thermique avec ladite partie du carter et une seconde surface en contact thermique avec le second dissipateur thermique (2) du capteur.

12. Moteur électrique selon la revendication 11, dans lequel:
- le premier dissipateur thermique comprend une pluralité d'ailettes de refroidissement saillantes (3-1);
- le capteur comprend un élément de support (5) comprenant une surface présentant une pluralité de rainures (5-1, 5-2, 5-3) adaptées pour recevoir la pluralité d'ailettes de refroidissement du premier dissipateur thermique.
